# EUROPEAN PATENT APPLICATION

(11) **EP 1 693 484 A2**
(43) Date of publication of application: **23.08.2006**
(21) Application number: 06250733.0
(22) Date of filing: 10.02.2006
(51) Int. Cl.: C23C 18/16, C23C 18/28, C23C 18/18, C25D 5/54

(54) **Plating Method**

(30) Priority: 15.02.2005 US 653184 P
(71) Applicant: Rohm and Haas Electronic Materials, L.L.C., Marlborough, Massachusetts 01752 (US)
(72) Inventor: Montano, Joseph R., Boston, Massachusetts 02111 (US); Reese, Jason A., Londonderry, New Hampshire 03053 (US); Little, Luke W., Brighton, Massachusetts 02135 (US)
(74) Representative: Kent, Venetia Katherine

(57) **Abstract**

Methods of improving the adhesion of metal layers to a substrate, such as an optical substrate, are provided. Such methods employ a layer of an adhesion promoting composition including a plating catalyst on the substrate before metal deposition. Also provided are devices made by such processes.

## Description

### Background of the Invention

The present invention relates generally to the field of metal plating. In particular, the present invention relates to the field of forming metal films on non-conductive substrates.

In the manufacture of electronic devices such as liquid crystal display ("LCD") devices, thin metal films are sometimes deposited as electrodes or circuitry on a substrate. Difficulties arise in the deposition of the metal films when the substrate has a complex surface profile, such as a curved surface or a three-dimensional surface. Other difficulties arise when the substrate surface has recesses or cavities. The surface profiles are typically reflected in the surface of the metal film which could result in recesses or cavities in the metal film.

These metal films are often deposited on non-conductive surfaces, such as optical substrates. Such metal films are deposited by a variety of techniques such as vacuum evaporation, sputtering and chemical vapor deposition. Such deposition processes typically require a reduced pressure environment which limits their applicability.

Certain pastes containing metal particles have been used to deposit metal films in electronic devices. After these pastes are disposed on a substrate, they are calcined into a metal film. The temperatures necessary for such calcinations limit the applicability of this technique.

Other metal deposition processes, such as electrolytic and electroless processes, are used to deposit a variety of metal films. Electrolytic metal deposition processes require a conductive substrate (cathode) in order to deposit a metal film. Electroless metal deposition processes typically utilize a plating bath containing a reducing agent. Electroless deposition techniques are advantageous in that they do not require a vacuum for deposition nor high temperatures nor a conductive substrate. These advantages make electroless metal deposition techniques attractive for metal deposition on non-conductive substrates, particularly optical substrates, used in electronic and/or optical devices. However, metals films deposited by electroless deposition typically have poor adhesion to the substrate as compared to other metal deposition methods, such as electrolytic deposition.

U.S. Pat. No. 6,661,642 (Allen et al.) discloses a method of forming a capacitor by depositing a dielectric layer comprising a plating dopant on a first dielectric layer on a substrate, and plating a conductive layer on the surface of the dielectric layer. This patent does not teach optical substrates.

There is a need for methods of depositing metal films on a substrate, particularly an optical substrate, where the metal film is deposited under conditions that do not adversely affect the substrate, where the metal film has good adhesion to the substrate and where the metal film does not reflect the irregularities of the substrate surface.

### Summary of the Invention

The present invention provides a method of depositing a metal film on a substrate including the steps of providing the substrate, disposing a layer of an adhesion promoting composition on the substrate, and disposing a metal layer on the adhesion promoting composition, wherein the adhesion promoting composition includes a film forming polymer, a plating catalyst and a porogen. In one embodiment, the substrate is an optical substrate.

Also provided by the present invention is a device including an optical substrate, an adhesion promoting composition layer disposed on the optical substrate, and a metal layer disposed on the adhesion promoting composition layer, wherein the adhesion promoting composition includes a film forming polymer and a plating catalyst.

### Brief Description of the Drawings

Figs. 1A-1C illustrate the process of the present invention.
Fig. 2 illustrates an alternate embodiment of the present invention.
Figs. 3A and 3B illustrate a further embodiment of the present invention.

### Detailed Description of the Invention

As used throughout this specification, the following abbreviations shall have the following meanings, unless the context clearly indicates otherwise: °C = degrees Centigrade; rpm = revolutions per minute; mol = moles; g = grams; L = liters; hr = hours; min = minute; sec = second; nm = nanometers; cm = centimeters; and wt% = percent by weight.

The terms "printed wiring board" and "printed circuit board" are used interchangeably throughout this specification. "Depositing" and "plating" are used interchangeably throughout this specification and include both electroless plating and electrolytic plating. "Polymer" includes both homopolymers and co-polymers and includes oligomers. The term "oligomer" includes dimers, trimers, tetramers and the like. "Acrylic polymers" include polymers containing as polymerized units one or more monomers of acrylic acid, alkyl acrylates, alkenyl acrylates, and aryl acrylates. "Methacrylic polymers" include polymers containing as polymerized units one or more monomers of methacrylic acid, alkyl methacrylates, alkenyl methacrylates, and aryl methacrylates. The term "(meth)acrylic" includes both acrylic and methacrylic and the term "(meth)acrylate" includes both acrylate and methacrylate. Likewise, the term "(meth)acrylamide" refers to both acrylamide and methacrylamide. "Alkyl" includes straight chain, branched and cyclic alkyl groups. "Cross-linker" and "cross-linking agent" are used interchangeably throughout this specification.

The articles "a" and "an" refer to the singular and the plural. Unless otherwise noted, all amounts are percent by weight and all ratios are by weight. All numerical ranges are inclusive and combinable in any order, except where it is clear that such numerical ranges are constrained to add up to 100%. In the figures, like reference numerals refer to like elements.

The present invention provides a method of depositing a metal film on a substrate including the steps of providing the substrate, disposing a layer of an adhesion promoting composition on the substrate, and disposing a metal layer on the adhesion promoting composition, wherein the adhesion promoting composition includes a film forming polymer, a plating catalyst and a porogen. In one embodiment, the adhesion promoting composition includes a silicon-containing material. In a further embodiment, the method includes the step of removing the porogen. In a further embodiment, the substrate is an optical substrate.

Substrates suitable for use in the present invention are typically non-conductive. Such substrates include organic, inorganic and organic-inorganic hybrids. Exemplary organic substrates include polymers such as epoxies, polysulfones, polyamides, polyarylene ethers, polyesters, acrylic polymers, methacrylic polymers, benzocyclobutenes, poly(aryl esters), poly(ether ketones), polycarbonates, polyimides, fluorinated polyimides, polynorbornenes, poly(arylene ethers), polyaromatic hydrocarbons, such as polynaphthalene, polyquinoxalines, poly(perfluorinated hydrocarbons) such as poly(tetrafluoroethylene), and polybenzoxazoles. Exemplary inorganic substrates include those containing silicon carbide, silicon oxides, silicon nitride, silicon oxyfluoride, boron carbide, boron oxide, boron nitride, boron oxyfluoride, aluminum carbide, aluminum oxides, aluminum nitride, aluminum oxyfluoride, silicones, siloxanes such as silsesquioxanes, silicates, and silazanes. Other suitable inorganic substrates include glasses such as borosilicate glass, alumino borosilicate glass, soda lime glass, indium-tin-oxide ("ITO"), metal oxides such as titanium dioxide and tin oxides, quartz, sapphire, diamond, carbon nanotubes, gallium arsenide, and silicon. In one embodiment, the substrate is not an inorganic high-k capacitor dielectric. By "high-k" is meant a dielectric material having a dielectric constant ≥ 7. In another embodiment the substrate is not a ceramic.

In one embodiment, the substrate is an optical substrate. By "optical substrate" is meant any substrate having a ≥ 50% transmittance of visible light. Such optical substrates may be organic, inorganic or organic-inorganic materials. Exemplary optical substrates include, but are not limited to, acrylic polymers, methacrylic polymers, polycarbonates, ITO, quartz, tin oxides, carbon nanotubes, glasses, silsesquioxanes, and siloxanes. Silsesquioxanes are polysilica materials having the general formula (RSiO_{1.5})ₙ. The R group is any organic radical such as alkyl, alkenyl and aryl. The organic radical may optionally be substituted, meaning that one or more of its hydrogens may be replaced by another group such as halogen, hydroxy or alkoxy. Suitable silsesquioxanes include, but are not limited to hydrogen silsesquioxane, alkyl silsesquioxane such as methyl silsesquioxane, aryl silsesquioxane such as phenyl silsesquioxane, and mixtures thereof, such as alkyl/hydrogen, aryl/hydrogen and alkyl/aryl silsesquioxane. Organic polymer optical substrates, such as those including a (meth)acrylic polymer, can be prepared by a variety of means, including that disclosed in U.S. Patent No. 6,224,805 (Fields et al.)

Optical substrates include optical and opto-electronic devices such as, but not limited to, display devices. As used herein, a "display device" refers to any display functioning off an electrode system. Exemplary display devices include, without limitation, LCDs, heads-up displays, plasma displays and light emitting polymer displays. Optical substrates also include light directing devices such as, but not limited to, waveguides, fiber optic cables, and optical packaging. Waveguides have a core material surrounded by a cladding material. When the substrate is a waveguide, the adhesion promoting composition may be deposited on the cladding material. Alternatively, the adhesion promoting composition may itself be used as a cladding material and be deposited directly on the core material. Still other optical substrates include light emitting diodes ("LEDs") such as polymer LEDs ("PLEDs") and organic LEDs ("OLEDs").

The adhesion promoting composition includes a film forming polymer, a plating catalyst and a porogen. A wide variety of film forming polymers may be used provided that such film forming polymers are compatible with the substrate and processing conditions employed. The film forming polymers may be organic, inorganic or organic-inorganic. Exemplary organic polymers include, without limitation, poly(meth)acrylates, polycarbonates, polyimides, polyamides, epoxies, polysulfones, polyarylenes, and polyarylene ethers. Such polymers may be homopolymers or copolymers. Blends of polymers may also be used. Exemplary inorganic polymers include without limitation silica, alumina, zirconia and mixtures thereof. Organic-inorganic polymers are any polymers containing organic moieties and metal and/or metalloid moieties. Exemplary organic-inorganic polymers include organic polysilicas. The term "organic polysilica" material refers to a material including silicon, carbon, oxygen and hydrogen atoms.

In one embodiment, the film forming polymer is an organic polysilica. In a further embodiment, exemplary organic polysilica materials are hydrolyzates or partial condensates including one or more silanes of formula (I), (II) or both (I) and (II):

RₐSiY₄₋ₐ (I)

R¹_{b}(R²O)_{3-b}Si(R³)_{c}Si(OR⁴)_{3-d}R⁵_{d} (II)

wherein R is hydrogen, (C₁-C₈)alkyl, (C₇-C₁₂)arylalkyl, substituted (C₇-C₁₂)arylalkyl, aryl, and substituted aryl; Y is any hydrolyzable group; a is an integer of 0 to 2; R¹, R², R⁴ and R⁵ are independently selected from hydrogen, (C₁-C₆)alkyl, (C₇-C₁₂)arylalkyl, substituted (C₇-C₁₂)arylalkyl, aryl, and substituted aryl; R³ is selected from (C₁₋C₁₀)alkylene, -(CH₂)ₕ-, -(CH2)ₕ₁-Eₖ-(CH₂)ₕ₂-, -(CH₂)ₕ-Z, arylene, substituted arylene, and arylene ether; E is selected from oxygen, NR⁶ and Z; Z is selected from arylene and substituted arylene; R⁶ is selected from hydrogen, (C₁-C₆)alkyl, aryl and substituted aryl; b and d are independently an integer of 0 to 2; c is an integer of 0 to 6; and h, h1, h2 and k are independently an integer from 1 to 6; provided that at least one of R, R¹, R³ and R⁵ is not hydrogen. "Substituted arylalkyl", "substituted aryl" and "substituted arylene" refer to an arylalkyl, aryl or arylene group having one or more of its hydrogens replaced by another substituent group, such as cyano, hydroxy, mercapto, halo, (C₁-C₆)alkyl, (C₁₋C₆)alkoxy, and the like. Typically, R is (C₁-C₄)alkyl, benzyl, hydroxybenzyl, phenethyl or phenyl, and more typically methyl, ethyl, iso-butyl, tert-butyl or phenyl. In one embodiment, a is 1. Suitable hydrolyzable groups for Y include, but are not limited to, halo, (C₁-C₆)alkoxy, acyloxy and the like. Preferred hydrolyzable groups are chloro and (C₁-C₂)alkoxy. In another embodiment, c is an integer of 1 to 6 and typically 1 to 4.

Suitable organosilanes of formula (I) include, but are not limited to, methyl trimethoxysilane, methyl triethoxysilane, phenyl trimethoxysilane, phenyl triethoxysilane, tolyl trimethoxysilane, tolyl triethoxysilane, propyl tripropoxysilane, iso-propyl triethoxysilane, iso-propyl tripropoxysilane, ethyl trimethoxysilane, ethyl triethoxysilane, iso-butyl triethoxysilane, iso-butyl trimethoxysilane, tert-butyl triethoxysilane, tert-butyl trimethoxysilane, cyclohexyl trimethoxysilane, cyclohexyl triethoxysilane, benzyl trimethoxysilane, benzyl triethoxysilane, phenethyl trimethoxysilane, hydroxybenzyl trimethoxysilane, hydroxyphenylethyl trimethoxysilane and hydroxyphenylethyl triethoxysilane.

Organosilanes of formula (II) preferably include those wherein R¹ and R⁵ are independently (C₁-C₄)alkyl, benzyl, hydroxybenzyl, phenethyl or phenyl. Preferably R¹ and R⁵ are methyl, ethyl, tert-butyl, iso-butyl and phenyl. Preferably R³ is (C₁-C₁₀)alkyl, -(CH₂)ₕ-, arylene, arylene ether and -(CH₂)ₕ₁-E-(CH₂)ₕ₂. Suitable compounds of formula (II) include, but are not limited to, those wherein R³ is methylene, ethylene, propylene, butylene, hexylene, norbornylene, cycloheylene, phenylene, phenylene ether, naphthylene and -CH₂-C₆H₄-CH₂-. It is further preferred that c is 1 to 4.

Suitable organosilanes of formula (II) include, but are not limited to, bis(trimethoxysilyl)methane, bis(triethoxysilyl)methane, bis(triphenoxysilyl)methane, bis(dimethoxymethylsilyl)methane, bis(diethoxymethyl-silyl)methane, bis(dimethoxyphenylsilyl)methane, bis(diethoxyphenylsilyl)methane, bis(methoxydimethylsilyl)methane, bis(ethoxydimethylsilyl)methane, bis(methoxy-diphenylsilyl)methane, bis(ethoxydiphenylsilyl)methane, bis(trimethoxysilyl)ethane, bis(triethoxysilyl)ethane, bis(triphenoxysilyl)ethane, bis(dimethoxymethylsilyl) ethane, bis(diethoxymethylsilyl)ethane, bis(dimethoxyphenylsilyl)ethane, bis(diethoxyphenyl-silyl)ethane, bis(methoxydimethylsilyl)ethane, bis(ethoxydimethylsilyl)ethane, bis(methoxy-diphenylsilyl)ethane, bis(ethoxydiphenylsilyl)ethane, 1,3-bis(trimethoxysilyl))propane, 1,3-bis(triethoxysilyl)propane, 1,3-bis(triphenoxysilyl)propane, 1,3-bis(dimethoxy-methylsilyl)propane, 1,3-bis(diethoxymethylsilyl)propane, 1,3-bis(dimethoxyphenyl-silyl)propane, 1,3-bis(diethoxyphenylsilyl)propane, 1,3-bis(methoxydimehylsilyl)propane, 1,3-bis(ethoxydimethylsilyl)propane, 1,3-bis(methoxydiphenylsilyl)propane, 1,3-bis(ethoxydiphenylsilyl)propane, and the like.

Suitable organic polysilica materials include, but are not limited to, silsesquioxanes, partially condensed halosilanes or alkoxysilanes such as partially condensed by controlled hydrolysis tetraethoxysilane having number average molecular weight of 500 to 20,000, organically modified silicates having the composition RSiO₃, O₃SiRSiO₃, R₂SiO₂ and O₂SiR₃SiO₂ wherein R is an organic radical, and partially condensed orthosilicates having Si(OR)₄ as the monomer unit. Silsesquioxanes are polymeric silicate materials of the type RSiO_{1.5} where R is an organic radical. Suitable silsesquioxanes are alkyl silsesquioxanes; aryl silsesquioxanes; alkyl/aryl silsesquioxane mixtures; and mixtures of alkyl silsesquioxanes. Silsesquioxane materials include homopolymers of silsesquioxanes, copolymers of silsesquioxanes or mixtures thereof. Such materials are generally commercially available or may be prepared by known methods.

In an alternate embodiment, the organic polysilica materials may contain a wide variety of other monomers in addition to the silicon-containing monomers described above. For example, the organic polysilica materials may further comprise a second cross-linking agent, and carbosilane moieties.

Suitable second cross-linking agents may be any known cross-linkers for silicon-containing materials. Typical second cross-linking agents include silanes of the formula Mⁿ(OR¹¹)ₙ wherein M is aluminum, titanium, zirconium, silicon, magnesium, or boron; R¹¹ is (C₁-C₆)alkyl, acyl, or Si(OR¹²)₃; R¹² is (C₁-C₆)alkyl or acyl; and n is the valence of M. In one embodiment, R¹¹ is methyl, ethyl, propyl or butyl. In another embodiment, M is aluminum, titanium, zirconium or silicon. It will be appreciated by those skilled in the art that a combination of such second cross-linkers may be used. When a second silicon cross-linking agent is used, the ratio of the mixture of silanes of formulae (I) and (II) to such second cross-linking agents organosilanes is typically from 99:1 to 1:99, preferably from 95:5 to 5:95, more preferably from 90:10 to 10:90.

Carbosilane moieties refer to moieties having a (Si-C)_{X} structure, such as (Si-A)_{X} structures wherein A is a substituted or unsubstituted alkylene or arylene, such as SiR₃CH₂-, -SiR₂CH₂-, =SiRCH₂-, and ≡SiCH₂-, where R is usually hydrogen but may be any organic or inorganic radical. Suitable inorganic radicals include organosilicon, siloxyl, or silanyl moieties. These carbosilane moieties are typically connected "head-to-tail", i.e. having Si-C-Si bonds, in such a manner that a complex, branched structure results. Particularly useful carbosilane moieties are those having the repeat units (SiHₓCH₂) and (SiH_{y-1}(CH=CH₂)CH₂), where x = 0 to 3 and y = 1 to 3. These repeat units may be present in the organic polysilica resins in any number from 1 to 100,000, and preferably from 1 to 10,000. Suitable carbosilane precursors are those disclosed in U.S. Patent Nos. 5,153,295 (Whitmarsh et al.) and 6,395,649 (Wu).

A wide variety of plating catalysts may be used in the present invention. The plating catalysts useful in the present invention are any that allow for plating of a conductive layer on the adhesion promoting composition. Preferably, the plating catalysts are conductive. Such plating may be by any suitable method such as electroless metal deposition and electrolytic metal deposition. Electroless plating includes immersion plating. Suitable plating catalysts include, but are not limited to, tin, lead, palladium, cobalt, copper, silver, gold, zinc oxide, conductive polymers, and graphite. Mixtures of plating catalysts may be advantageously used, such as palladium/tin mixtures. In one embodiment, particularly suitable plating catalysts are tin, palladium, cobalt, copper, silver, gold, zinc oxide and mixtures thereof.

When metallic plating catalysts are used, they may be present in the adhesion promoting composition layer in a variety of forms, including, but not limited to, elemental metal, metal alloys, metal compounds such as metal oxides and metal salts, metal complexes, or metal precursors that can be converted to conducting metal structures. The metal or metal alloys may be used as particles, needles, rods, crystallites or other suitable structure. The plating catalysts may be converted to conducting metal structures by heat, light or other external means. Exemplary metal precursors include metal organic deposition reagents, silver halide materials, and the like. In one embodiment, when the plating catalyst is a metal or metal alloy it is present as fine particles (1 nm to 10 µm). Such fine metal or metal alloy particles may be prepared by a variety of means, such as combustion chemical vapor deposition, mechanical milling, etching of biphasic monoliths, ultrasound, chemical reduction, vacuum deposition, and the like.

A wide variety of conductive polymers are known, such as, but not limited to, polyacetylenes and polypyrroles. Any conductive polymer may be used in the present invention. Typically, the conductive polymers used are stable upon heating to > 250° C.

Plating catalysts are present in the adhesion promoting composition in an amount sufficient to provide for plating of a conductive layer on the adhesion promoting composition layer. The minimum amount necessary will depend upon the particular plating catalyst and the conductive layer to be deposited. For example, when the conductive layer is to be deposited electrolytically, the plating catalyst must be present in an amount to be sufficiently conductive to allow for electroplating of the conductive layer. When the conductive layer is to be deposited by immersion plating, sufficient plating catalyst that is more electropositive than the metal to deposited must be present in an amount sufficient to allow the necessary displacement (immersion) plating to occur. Such minimum amounts are well within the ability of those skilled in the art. The plating catalysts may typically be present in the adhesion promoting layer up to 50% by volume. Higher amounts of plating catalyst may advantageously be used. In general, the amount of plating catalyst is up to 45% by volume and more typically up to 40% by volume.

A wide variety of porogens may be used in the present invention. As used herein, the term "porogen" refers to a material that is removable from the adhesion promoting composition. Upon removal, the porogen may, but does not have to, form pores or crevices in the surface of the adhesion promoting composition layer. While not wishing to be bound by theory, the porogens may, in some cases, form pores throughout the adhesion promoting composition layer. Any material which can be dispersed within, suspended within, co-dissolved with, or otherwise combined with the film forming polymer and plating catalyst and which may be, but does not have to be, subsequently removed from the adhesion promoting composition may suitably be used. Particularly suitable as porogens are organic polymers or compounds which can be selectively etched or removed from the adhesion promoting composition and preferably without adversely affecting the adhesion promoting composition layer. In one embodiment, the porogen is selected such that it is substantially non-aggregated or non-agglomerated in the adhesion promoting composition. Such non-aggregation or non-agglomeration allows for a more uniform distribution of porogen throughout the adhesion promoting composition. It is preferred that the porogen is a polymer particle. It is further preferred that the porogen polymer particle is soluble or miscible in any solvent used to deposit the adhesion promoting composition.

The porogens may be polymers such as linear polymers, star polymers, dendritic polymers and polymeric particles, or may be high boiling solvents, or may be monomers or polymers that are co-polymerized with a film forming polymer to form a block copolymer having a labile (removable) component. In an alternative embodiment, the porogen may be pre-polymerized or pre-reacted with the film forming polymer or alternatively the monomers used to form the film forming polymer or both.

Suitable block copolymers having labile components useful as porogens are those disclosed in U.S. Patent Nos. 5,776,990 and 6,093,636. Such block copolymers may be prepared, for example, by using as pore forming material highly branched aliphatic esters that have functional groups that are further functionalized with appropriate reactive groups such that the functionalized aliphatic esters are incorporated into, i.e. copolymerized with, the vitrifying matrix (i.e. the film forming polymer). Such block copolymers include, but are not limited to, benzocyclobutenes, poly(aryl esters), poly(ether ketones), polycarbonates, polynorbornenes, poly(arylene ethers), polyaromatic hydrocarbons, such as polynaphthalene, polyquinoxalines, poly(perfluorinated hydrocarbons) such as poly(tetrafluoroethylene), polyimides, polybenzoxazoles and polycycloolefins.

Particularly suitable porogens are cross-linked polymer particles, such as those disclosed in U.S. Patent Nos. 6,271,273 B 1 (You et al.) and 6,420,441 (Allen et al.). The polymeric porogens comprise as polymerized units one or more monomers and one or more cross-linking agents. Suitable monomers useful in preparing the porogens include, but are not limited to, (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, and aromatic monomers. Such porogens may be prepared by a variety of polymerization methods, including emulsion polymerization and solution polymerization, and preferably by solution polymerization.

Such porogens typically have a molecular weight in the range of 5,000 to 1,000,000, more typically 10,000 to 500,000, and still more typically 10,000 to 100,000. When polymeric particles are used as the porogens, they may have any of a variety of mean particles sizes, such as up to 1000 nm. Typical mean particle size ranges are from 0.5 to 1000 nm, more typically from 0.5 to 200 nm, yet more typically from 0.5 to 50 nm, and most typically from 1 nm to 20 nm.

The porogen particles are typically cross-linked. Typically, the amount of cross-linking agent is at least about 1 % by weight, based on the weight of the porogen. Up to and including 100% cross-linking agent, based on the weight of the porogen, may be effectively used in the porogen particles. In general, the amount of cross-linker is from 1% to 80%, and more typically from 1% to 60%. A wide variety of cross-linking agents may be used. Such cross-linking agents are multi-functional monomers and are well-known to those skilled in the art. Exemplary cross-linking agents are disclosed in U.S. Patent No. 6,271,273 (You et al.). Particularly suitable cross-linking agents are monomers containing 2 or more ethylenically unsaturated groups.

Porogen particles having a wide range of particle sizes may be used in the present invention. The particle size polydispersity of these materials is in the range of 1 to 20, typically 1.001 to 15, and more typically 1.001 to 10. It will be appreciated that particles having a uniform particle size distribution (a particle size polydispersity of 1 to 1.5) or a broad particle size distribution may be effectively used in the present invention.

Optionally, the adhesion promoting composition may include one or more additional components such as viscosity modifiers, surfactants, solvents and polymerization catalysts. A wide variety of solvents may be used depending upon the film forming polymer, plating catalyst and porogen selected. Exemplary solvents include, without limitation: water; alcohols such as methanol, ethanol, propanol, butanol, hexanol and heptanol; esters such as ethyl acetate, ethyl formate, n-amyl acetate, n-butyl acetate and ethyl lactate; carbonates such as propylene carbonate; ketones such as acetone, methyl isobutyl ketone, diisobutyl ketone, 2-heptanone, cyclopentanone and cyclohexanone; lactones such as γ-butyrolactone and γ-caprolactone; glycols such as ethylene glycol, diethylene glycol, triethylene glycol, propylene glycol, dipropylene glycol, and tripropylene glycol; glycol derivatives such as propylene glycol methyl ether, propylene glycol dimethyl ether, dipropylene glycol methyl ether, dipropylene glycol dimethyl ether, and propylene glycol methyl ether acetate; hydrocarbons such as xylene, mesitylene; ethers such as diphenyl ether and anisole; and nitrogen-containing compounds such as N-methyl-2-pyrrolidone and N,N'-dimethylpropyleneurea. Mixtures of solvents may be used.

The adhesion promoting composition may be prepared by combining the film forming polymer, plating catalyst, porogen and any optional component in any order. In general, the film forming polymer is present in the adhesion promoting composition in an amount of 0.005 to 50 wt% based upon the weight of the adhesion promoting composition, and more typically from 0.05 to 25 wt% and still more typically from 0.1 to 5 wt%. Porogens are typically present in the adhesion promoting compositions in an amount of 1 to 60 wt%, based on the weight of the adhesion promoting composition, more typically from 3 to 50 wt%, and still more typically form from 50 to 45 wt%. The ratio of film forming polymer to porogen is in the range of 1:99 to 99:1 on a weight basis of these components, more typically from 10:90 to 90:90 and still more typically from 10:90 to 50:50.

The adhesion promoting composition may be disposed on the substrate by any suitable means such as, but not limited to, spin coating, dip coating, roller coating, curtain coating, screen printing, ink jet printing, contact printing, and spray coating. Such methods are well known to those skilled in the art. Optionally, the substrates may be cleaned prior to the deposition of the adhesion promoting composition. A wide variety of cleaners may be used, such as but not limited to,water, organic solvents, and alkaline cleaners such as tetraalkyl ammonium hydroxide and alkali metal hydroxides. More than one such cleaning step may be used.

The layer of the adhesion promoting composition may have a variety of thicknesses. The particular thickness will, in part, depend upon the particular application. For example, when the substrate is a fiber optic cable, the adhesion promoting composition will generally be sufficiently thin to remain somewhat flexible. In general, the layer of the adhesion promoting composition has a thickness of 1nm to 100 µm. More typically, the layer has a thickness of 1 to 500 nm, and still more typically from 5 to 50 nm, after any curing step.

The film forming polymer may be further cured after the adhesion promoting composition is disposed on the substrate. As used herein, the terms "cure" and "curing" refer to polymerization, condensation or any other reaction where the molecular weight of a compound is increased. The step of solvent removal alone is not considered "curing" as used in this specification. However, a step involving both solvent removal and, e.g., polymerization is within the term "curing" as used herein. For example, the film forming polymer may be further polymerized by exposure to heat, light or by activating a polymerization catalyst. In the case of an organic polysilica, the organic polysilica film may be further polymerized upon exposure to a base or acid. When an organic polysilica is used, it is preferred that the organic polysilica be cured prior to deposition of the metal layer.

The present adhesion promoting composition layer contains a plating catalyst in an amount sufficient to provide direct plating of a conductive layer on the adhesion promoting composition. The adhesion promoting composition may be metallized by a variety of methods, such as without limitation electroless plating, electrolytic plating, and immersion plating. Suitable conductive layers include, but are not limited to copper, silver, gold, nickel, tin, lead, tin-lead, tin-copper, tin-bismuth, tin-silver, tin-silver-copper, platinum, palladium and molybdenum. Such conductive layers may be further alloyed with a suitable alloying metal, such as, but not limited to, bismuth, indium, and antimony. More than one alloying metal may be used.

Electroless plating may suitably be accomplished by a variety of known methods. Suitable metals that can be electrolessly plated include, but are not limited to, copper, gold, silver, nickel, palladium, tin, and lead. Immersion plating may be accomplished by a variety of known methods. Gold, silver, tin and lead may suitably be deposited by immersion plating. Such electroless and immersion plating baths are well known to those skilled in the art and are generally commercially available from a variety of sources, such as Rohm and Haas Electronic Materials (Marlborough, Massachusetts).

Electrolytic plating may be accomplished by a variety of known methods. Exemplary metals that can be deposited electrolytically include, but are not limited to, copper, gold, silver, nickel, palladium, platinum, tin, tin-lead, tin-copper, tin-bismuth, tin-silver, and tin-silver-bismuth. Such electroplating baths are well known to those skilled in the art and are commercially available from a variety of sources, such as Rohm and Haas Electronic Materials.

Those skilled in the art will appreciate that additional conductive layers may be deposited on the first conductive layer. Such additional conductive layers may be the same or different from the first conductive layer. The additional conductive layers may be deposited by any suitable means such as electrolessly, electrolytically, immersion plating, chemical vapor deposition, physical vapor deposition, and sputtering. For example, when the conductive layer is deposited by electroless plating, such electroless metal deposit may be subsequently electrolytically plated to build up a thicker metal deposit. Such subsequent electrolyticly deposited metal may be the same as or different from the electrolessly deposited metal. Alternatively, additional electrolessly deposited metal layers and/or immersion deposited metal layers may be deposited on the first conductive layer.

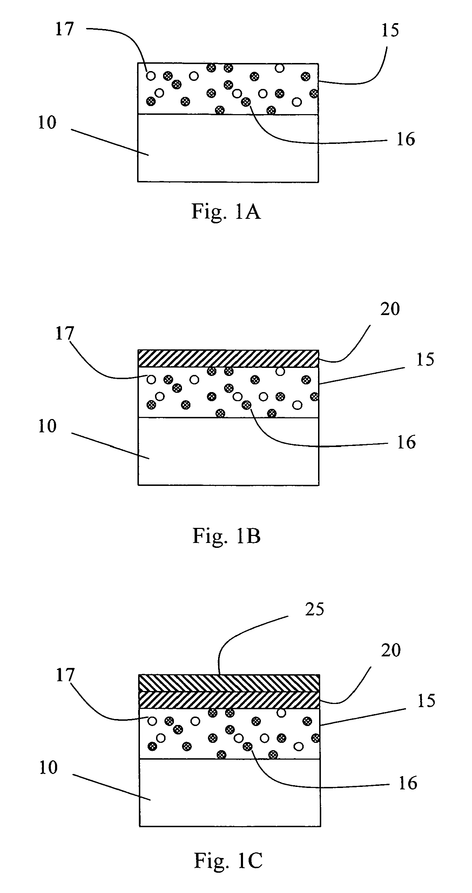

Figs. 1A-1C illustrate the present process. Referring to Fig. 1A, a layer of adhesion promoting composition **15** is disposed on substrate 10, such as an optical substrate, by any suitable means. Adhesion promoting composition **15** includes plating catalyst 16 and porogen **17.** Plating catalyst **16** could be, for example, a metal salt such as palladium acetate. Porogen **17** could be a cross-linked polymeric particle, such as a cross-linked (meth)acrylic polymer.

Optionally, adhesion promoting composition **15** is cured. In one embodiment, when adhesion promoting composition **15** is an organic polysilica material it is exposed to heat optionally in the presence of acid or base to cure the organic polysilica material.

A first metal layer **20,** such as copper or nickel, is then deposited on adhesion promoting composition layer **15** such as by electroless plating. See Fig. 1B. Metal layer **20** may have a thickness in the range of 10 to 1000 nm, although thinner or thicker films may be used.

Additional metal layers may be deposited on the first metal layer. Referring to Fig. 1C, second metal layer **25,** such as copper, may be deposited on first metal layer **20.** Second metal layer **25** may be deposited by any suitable means such as electroless plating or electrolytic plating.

Alternatively, the porogen may be removed from the adhesion promoting composition before or after metal deposition, and typically before metal deposition. In general, the porogen is removed under conditions which do not adversely affect the film forming polymer and plating catalyst. By "removable" is meant that the porogen depolymerizes or otherwise breaks down into volatile components or fragments which are then removed from, or migrate out of, the adhesion promoting composition layer yielding pores. Such resulting pores may fill with any carrier gas used in the removal process. Any procedures or conditions which at least partially remove the porogen without substantially degrading the adhesion promoting composition layer, that is, where less than 5% by weight of each of the film forming polymer and plating catalyst is lost, may be used. It is preferred that the porogen is substantially removed. Typical methods of removal include, but are not limited to: chemical etching, exposure to heat, pressure or radiation such as, but not limited to, actinic, IR, microwave, UV, x-ray, gamma ray, alpha particles, or electron beam. It will be appreciated that more than one method of removing the porogen may be used, such as a combination of heat and actinic radiation. It is preferred that the adhesion promoting composition layer is exposed to heat to remove the porogen. It will also be appreciated by those skilled in the art that other methods of porogen removal may be employed.

The porogens of the present invention can be thermally removed under a variety of atmospheres, including but not limited to, vacuum, air, nitrogen, argon, mixtures of nitrogen and hydrogen, such as forming gas, or other inert or reducing atmosphere, as well as under oxidizing atmospheres. Typically, the porogens of the present invention may be removed at a wide range of temperatures such as from 150° to 650° C, and preferably from 225° to 500° C. Such heating may be provided by means of an oven, flame, microwave and the like. It will be recognized by those skilled in the art that the particular removal temperature of a thermally labile porogen will vary according to composition of the porogen. For example, increasing the aromatic character of the porogen and/or the extent of cross-linking will typically increase the removal temperature of the porogen. Typically, the porogens of the present invention are removed upon heating for a period of time in the range of 1 to 120 minutes. After removal from the adhesion promoting composition, 0 to 20% by weight of the porogen typically remains.

Upon removal of the porogens, a textured adhesion promoting composition having pores or other texturing is obtained, where the size of the pores is preferably substantially the same as or smaller than the particle size of the porogen. In general, pore sizes of up to 1,000 nm, such as that having a mean pore size in the range of 0.5 to 1000 nm, are obtained. It is preferred that the mean pore size is in the range of 0.5 to 200 nm, more preferably from 0.5 to 50 nm, and most preferably from 1 nm to 20 nm.

Referring to Fig. 1B, porogen **17** may be removed from adhesion promoting composition layer **15** prior to deposition of metal layer **20.** Such porogen removal may be by any suitable means, such as by heating. The removal of the porogens provides pores **17** or other texturing in adhesion promoting composition layer **15.**

Also contemplated by the present invention is a device comprising an optical substrate, an adhesion promoting composition layer disposed on the optical substrate, and a metal layer disposed on the adhesion promoting composition layer, wherein the adhesion promoting composition comprises a film forming polymer and a plating catalyst. The porogen may or may not be present in such a device.

In one embodiment, the method further includes an annealing step following metal deposition. For example, when nickel is electrolessly deposited on the adhesion promoting composition, it may be annealed by heating the substrate at 200° C under nitrogen. When copper is deposited as a first metal layer on the adhesion promoting composition or as a second metal layer on a first metal layer, such as nickel, it may be annealed by heating the substrate at 120° C under either air or nitrogen. It will be appreciated that other annealing temperatures and atmospheres may be used. Such annealing steps are well within the ability of those skilled in the art. If the porogen is not removed prior to metal deposition, the porogen may be removed during any metal annealing step.

It will be appreciated that other steps may be performed in this process. For example, an underlayer may be disposed between the substrate and adhesion promoting composition layer. Such underlayer typically does not contain a plating catalyst, but optionally may contain such plating catalyst. In one embodiment, the underlayer includes a film forming polymer and optionally a porogen. In a further embodiment, the underlayer includes the same film forming polymer as in the adhesion promoting composition layer. In another embodiment, the underlayer is inorganic. Exemplary inorganic underlayers include without limitation ITO, silicon nitride, and silicon carbide. When multiple underlayers are used, they may be the same as or different from each other.

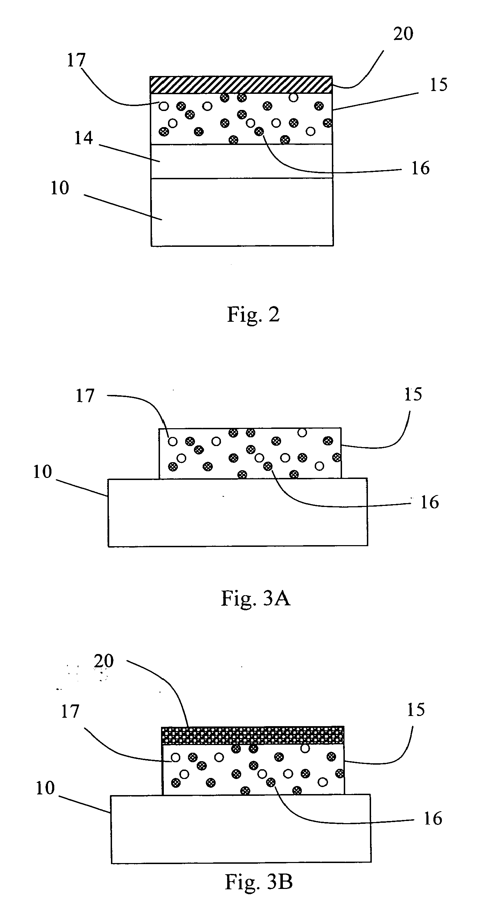

Fig. 2 illustrates an alternate embodiment of the present invention. Underlayer **14** is disposed on substrate **10** such as an optical substrate by any suitable means such as those described above for the deposition of the adhesion promoting composition layer. For example, underlayer **14** is a layer of a composition containing a film forming polymer, particularly an organic polysilica material. Alternatively, underlayer **14** is ITO or silicon nitride. Next, adhesion promoting layer **15** is disposed on underlayer **14.** Adhesion promoting composition **15** includes plating catalyst **16** and porogen **17as** well as a film forming polymer (not shown). Porogen **17** may optionally be removed prior to the deposition of metal layer **20,** such as nickel deposited electrolessly.

While not intending to be bound by theory, it is believed that the porogens in the present adhesion promoting compositions may function to provide a porous or otherwise textured adhesion promotion composition layer upon their removal. Another possibility is that the porogen also functions as a lubricant during the deposition of the adhesion promoting composition layer.

Metal layers deposited on the adhesion promoting compositions of the present invention generally do not blister after 72 hours of storage at room temperature (20-25° C). Such metal films also show increased adhesion to the substrate in a tape test as compared to the same metal films deposited directly on the substrate.

It will be appreciated by those skilled in the art that the present invention may be useful in the selective metallization of a substrate. For example, the present adhesion promoting compositions may be used metal layers in a desired pattern on a substrate such as an optical substrate. Fig. 3A and 3B illustrates the selective metallization of a substrate. In Fig. 3A, a layer adhesion promoting composition **15** is disposed on substrate **10** in a manner that provides a pattern. Adhesion promoting composition layer **15** includes plating catalyst **16** and porogen **17.** Next, metal layer **20** is selectively deposited on adhesion promoting composition layer **15.**

A desired pattern of the adhesion promoting composition may be provided by ink jet printing, screen printing, contact printing, and coating through a mask. Other suitable means known in the art may also be used. For example, the adhesion promoting composition may be applied to the entire substrate surface and then selectively removed from the substrate in areas where a metal layer is not desired. In an alternate embodiment, the adhesion promoting composition may be made photoimageable, such as by the addition of a photoactive material to the composition. Exemplary photoimageable film forming polymers useful in the present adhesion promoting composition are those disclosed as waveguides in U.S. Patent No. 6,731,857 (Shelnut et al.) and as photoresists in U.S. Patent No. 6,803,171 (Gronbeck et al.). Those skilled in the art will appreciate other photoimageable materials that could be used in the present adhesion promoting compositions.

In yet another embodiment, the adhesion promoting composition may be selectively catalyzed such as by activating the plating catalyst through the use of a laser, such as a KrF eximer laser with a wavelength of 248 nm. The use of such a laser in the activation of palladium catalysts is described in U.S. Patent No. 6,319,564 (Naundorf et al.).

The following examples are expected to illustrate further various aspects of the present invention, but are not intended to limit the scope of the invention in any aspect.

### Example 1

A 10 cm x 10 cm glass substrate was cleaned as follows: contacting with isopropanol at 20° C for 5 min., rinsing with cold water at 20° C for 5 min., contacting with a 1% w/w solution oftetramethyl ammonium hydroxide in water at 50° for 5 min., rinsing with cold water at 20° C for 4 min., and drying with compressed air and in an oven (120° C for 10 min.).

An underlayer composition was prepared containing 6 wt% of phenyl-methyl silsesquioxane oligomer having the general formula (C₆H₅SiO_{1.5})(CH₃SiO_{1.5}), 0.5 wt% of a siloxane containing surfactant, the balance being propylene glycol monomethyl ether acetate.

An adhesion promoting composition was prepared containing 1 wt% of phenyl-methyl silsesquioxane oligomer having the general formula (C₆H₅SiO_{1.5})(CH₃SiO_{1.5}), 0.5 wt% of a siloxane containing surfactant, 20 g/L of palladium acetate as a plating catalyst, and 20 wt% of a porogen including as polymerized units methoxy-capped polypropylene oxide methacrylate/trimethylolpropane triacrylate/acrylic acid in a ratio of 80/15/5 (20% solids), the balance being propylene glycol monomethyl ether acetate.

A layer of the underlayer composition was spin coated on the glass substrate at 1000 rpm for 30 seconds. The underlayer had a thickness of approximately 150 nm. A layer of the adhesion promoting composition was then deposited on the underlayer composition by spin coating under the same conditions. The thickness of the adhesion promoting composition layer was approximately 20 nm. The underlayer and adhesion promoting composition layers were then cured at 200° C for 60 min.

The adhesion promoting composition layer was next contacted with a commercially available electroless nickel plating bath (NIPOSIT 468, available from Rohm and Haas Electronic Materials, Marlborough, Massachusetts) using recommended plating conditions. Nickel was deposited at a rate of approximately 25 nm/min. After 4 minutes of contact, the sample was removed from the plating bath, dried at 110° C for 10 min. and then annealed at 120° C for 60 min. The sample contained a nickel layer having a thickness of approximately 100 nm on the adhesion promoting layer.

### Example 2

The nickel plated sample from Example 1 was contacted with a commercially available electrolytic copper plating bath (EP 1100, available from Rohm and Haas Electronic Materials) using recommended plating conditions. After 2 minutes, the sample was removed from the plating bath and dried in air. A layer of copper (approximately 125 nm thick) was deposited on the electroless nickel layer.

### Example 3

The process of Example 1 was repeated. The electroless nickel plated sample was then contacted with a commercially available electroless copper plating bath (CIRCUPOSIT 880, available from Rohm and Haas Electronic Materials) using recommended plating conditions. Copper was deposited on the nickel layer at a rate of 8-12 nm/min. After removal from the plating bath, the sample was dried at 110° C for 10 minutes and then annealed at 120° C for 60 minutes. The sample contained a layer of electroless copper deposited on the layer of electroless nickel.

### Example 4

The procedure of Example 1 is repeated. The electroless nickel plated sample is then contacted with a commercially available immersion gold plating bath (such as AUROLECTROLESS SMT, available from Rohm and Haas Electronic Materials) using recommended plating conditions. After an appropriate time, the sample is removed from the plating bath and optionally is rinsed and dried. A sample containing an immersion deposited gold layer on the electroless nickel layer is expected.

### Example 5

The procedure of Example 1 is repeated except that the electroless nickel bath is replaced with a conventional electroless copper plating bath (CIRCUPOSIT 880). After an appropriate time, the sample is removed from the plating bath and optionally is rinsed and dried. A sample having an electroless copper layer deposited on the adhesion promoting layer is expected.

### Example 6

The sample from Example 5 is then contacted with a commercially available immersion silver plating bath (such as STERLING, available from MacDermid, Waterbury, Connecticut) using recommended plating conditions. After an appropriate time, the sample is removed from the plating bath and optionally is rinsed and dried. A sample having an immersion deposited silver layer on the electroless copper layer is expected.

### Example 7

The procedure of Example 1 is repeated except that the components in the adhesion promoting composition are as follows.

| Sample | Component | Amount |
|---|---|---|
| 7A | Plating Catalyst: Palladium Acetate | 20 g/L |
| | Porogen: phenoxy capped polyethylene oxide acrylate / styrene / trimthylolpropane triacrylate (80/15/5 ratio by weight) | 25 wt% |
| | Polymer: a siloxane condensation polymer made from 55 wt% methyl triethoxy silane and 45 wt% tetraethyl ortho silicate | 0.01 wt% |
| 7B | Plating Catalyst: Palladium Acetate | 25 g/L |
| | Porogen: styrene/divinyl benzene (75/25 ratio by weight) | 17 wt% |
| | Polymer: a siloxane condensation polymer made from 35 wt% methyl triethoxy silane, 20 wt% phenyl triethoxy silane and 45 wt% tetraethyl ortho silicate | 10 wt% |
| 7C | Plating Catalyst: Palladium/tin colloid | 12 g/L |
| | Porogen: butyl acrylate / (trimethoxylsilyl)propylmethacrylate / divinyl benzene (10/80/10 ratio by weight) | 8 wt% |
| | Polymer: a siloxane condensation product of 20 wt% phenyl triethyoxy silane, 60 wt% of methyl triethoxy silane and 20% dimethyl diethoxy silane. | 0.05 wt% |
| 7D | Plating Catalyst: graphite | 10 g/L |
| | Porogen: butyl acrylate / propylene glycol dimethacrylate (90/10 ratio by weight) | 30 wt% |
| | Polymer: methylsilsesquioxane | 1.5 wt% |

The above adhesion promoting compositions are expected to provide a sample having an electrolessly deposited nickel layer.

### Example 8

The procedure of Example 2 was repeated a number of times. Electrodeposited copper layers up to a thickness of 5000 nm were obtained.

Samples containing the electrodeposited copper on electrolessly plated nickel were evaluated for adhesion using a tape test. A piece of tape (3M 610, brand) 2.5 x 10 cm was applied to the sample and then removed. The tape and the sample we visually examined to determined if any of the metal layers were removed from the sample. Samples were considered to pass this test when no metal was removed with the tape. Samples containing up to 500 nm of electrolytically deposited copper on the electrolessly deposited nickel layer passed this tape test.

### Example 9

A number of samples of the invention were prepared by the process of Example 3. Copper layers having a thickness of >500 nm were deposited.

Comparative samples were prepared by repeating the process of Example 1, except that the adhesion promoting composition did not contain any plating catalyst. After the deposition of the adhesion promoting composition, the sample was then contacted with a separate bath containing palladium acetate. The comparative samples were then electrolessly plated with nickel according to Example 1. Following the deposition of the nickel layer, the samples were contacted with the electroless copper plating bath according to Example 3. Such samples contained up to 150 nm of electrolessly deposited copper.

Samples of the invention and the comparative samples were evaluated according to the tape test of Example 8. Samples of the invention having up to 200 nm of electrolessly deposited copper passed the tape test. For the comparative sample, the maximum thickness of electrolessly deposited copper that passed the tape test was 120 nm.

It can be clearly seen the present process provides thicker metal layers and that such metal layers have improved adhesion compared to samples that do not contain a plating catalyst in the adhesion promoting composition.

### Example 10

The procedure of Example 9 was repeated except that the electroless nickel layer was replaced with a first electroless copper layer, which was subsequently plated with a second electroless copper layer. Samples of the invention having up to 200 nm of electrolessly deposited copper passed the tape test. For the comparative samples, the maximum thickness of electrolessly deposited copper that passed the tape test was 120 nm.

It can be clearly seen the present process provides thicker metal layers and that such metal layers have improved adhesion compared to samples that do not contain a plating catalyst in the adhesion promoting composition.

## Claims

1. A method of depositing a metal film on a substrate comprising the steps of providing the substrate, disposing a layer of an adhesion promoting composition on the substrate, and disposing a metal layer on the adhesion promoting composition, wherein the adhesion promoting composition comprises a film forming polymer, a plating catalyst and a porogen. In one embodiment, the substrate is an optical substrate.

2. The method of claim 1 wherein the film forming polymer is an organic polysilica.

3. The method of claim 1 wherein the porogen is a cross-linked polymeric particle.

4. The method of claim 1 wherein the metal layer is deposited by electroless plating.

5. The method of claim 1 wherein the substrate is an optical substrate.

6. The method of claim 1 wherein the plating catalyst is metallic.

7. A device comprising an optical substrate, an adhesion promoting composition layer disposed on the optical substrate, and a metal layer disposed on the adhesion promoting composition layer, wherein the adhesion promoting composition comprises a film forming polymer and a plating catalyst.

8. The device of claim 7 wherein the film forming polymer is an organic polysilica.

9. The device of claim 7 wherein the porogen is a cross-linked polymeric particle.

10. The device of claim 7 wherein the substrate is an optical substrate.
